# EUROPEAN PATENT APPLICATION

(11) **EP 2 343 139 A1**
(43) Date of publication of application: **13.07.2011**
(21) Application number: 11150605.1
(22) Date of filing: 11.01.2011
(51) Int. Cl.: B22D 11/14, B22D 27/04, C30B 11/00, C30B 15/00, C30B 15/06, C30B 15/10, C30B 15/14, C30B 15/34, C30B 27/00, C30B 27/02, C30B 29/06, C30B 35/00, C30B 29/64

(54) **Apparatus and method for continuous casting of monocrystalline silicon ribbon**

(30) Priority: 12.01.2010 US 685701
(71) Applicant: SPX Corporation, Charlotte, NC 28277 (US)
(72) Inventor: Tao Li, Tao, Sichuan 610072 (CN); Qingyue Pan, Qingyue, Pittsford, NY 14534 (US); Drew Knofel, Drew, Fairport, NY 14450 (US)
(74) Representative: GROSSE SCHUMACHER KNAUER VON HIRSCHHAUSEN

(57) **Abstract**

An apparatus for forming monocrystalline silicon ribbon. The apparatus includes a crucible wherein a silicon melt is formed. The melt is allowed to flow substantially vertically out of the crucible and to contact a silicon seed crystal before solidification. Pursuant to solidification into a ribbon, further cooling of the ribbon occurs under controlled conditions and the ribbon is ultimately cut. Also, a method for forming monocrystalline silicon ribbon using the aforementioned apparatus.

## Description

### FIELD OF THE INVENTION

The present invention relates generally to devices and systems used in semiconductor/photovoltaic processing. The present invention also relates generally to methods used during semiconductor/photovoltaic processing.

### BACKGROUND OF THE INVENTION

Continuous casting technology has long been used to produce billets of aluminum and other nonferrous metals in the metallurgy industry. In recent years, however, this technology has been modified to produce silicon (Si) ribbon for solar cell applications. More specifically, some emerging silicon ribbon technologies such as Dendritic Web (WEB), Edge-defined Film-fed Growth (EFG), String-Ribbon (SR), Silicon Film™ (SF) and Ribbon Growth on Substrate (RGS) have either been commercialized or are under development.

Compared to conventional crystalline silicon technologies such as Czochralski (CZ) or Directional Solidification System (DSS) growth, silicon ribbon technologies eliminate the traditional wafer-cutting process which can consume over 50% of the silicon grown. In addition, the silicon ribbon technologies benefit from reduced energy consumption and can be quite cost-effective relative to conventional crystalline silicon technologies.

The above notwithstanding, almost all currently available silicon ribbon technologies produce silicon ribbons with microstructures that are either equiaxed or that include columnar silicon grains. In other words, almost all currently available silicon ribbon technologies produce multi-crystalline silicon. As such, the significant amount of grain boundaries, in conjunction with the high concentration of impurities and defects along these boundaries, limits the maximum efficiency of solar cells made therefrom.

The only currently available silicon ribbon technology that does produce monocrystalline silicon is the above-mentioned WEB technology. However, when implementing this technology, removal of the dendrites used to initiate silicon growth can be problematic. Also, silicon grown using WEB technology includes twin planes, typically formed in the middle of the web.

### SUMMARY OF THE INVENTION

At least in view of the above, it would be desirable to provide novel devices and/or systems capable of producing relatively low-cost and high-quality monocrystalline silicon ribbons. It would also be desirable for the produced silicon ribbons to be applicable to, for example, solar applications. In addition, it would also be desirable to provide novel methods for producing such relatively low-cost and high-quality monocrystalline silicon ribbons.

The foregoing needs are met, to a great extent, by one or more embodiments of the present invention. According to one such embodiment, an apparatus for forming a silicon ribbon is provided. The apparatus includes a crucible configured to contain a silicon melt. The apparatus also includes a channel positioned adjacent to the crucible and configured to allow the melt to flow therethrough. In addition, the apparatus also includes a channel heating system positioned adjacent to the channel and configured to control temperature of the melt flowing through the channel. Further, the apparatus also includes a holder configured to support a silicon seed crystal in contact with the melt and further configured to move the silicon seed crystal in a substantially horizontal direction.

In accordance with another embodiment of the present invention, a method of forming a silicon ribbon is provided. The method includes heating feedstock (e.g., solid silicon) in a vessel to form a melt. The method also includes channeling a portion of the melt out of the vessel in a substantially horizontal direction. In addition, the method also includes promoting single-crystal silicon formation by contacting the portion of the melt with a seed crystal as the portion of the melt moves away from the vessel and solidifies.

In accordance with yet another embodiment of the present invention, another apparatus for forming a silicon ribbon is provided. The apparatus includes means for heating silicon to form a melt. The apparatus also includes means for channeling a portion of the melt out of the means for heating in a substantially horizontal direction. Further, the apparatus also includes means for controlling how rapidly the portion of the melt cools as the portion moves away from the means for heating. In addition, the apparatus also includes means for promoting single-crystal silicon formation, wherein the means for promoting is placed in contact with the portion of the melt as the portion of the melt moves away from the means for heating and solidifies.

There has thus been outlined, rather broadly, certain embodiments of the invention in order that the detailed description thereof herein may be better understood, and in order that the present contribution to the art may be better appreciated. There are, of course, additional embodiments of the invention that will be described below and which will form the subject matter of the claims appended hereto.

In this respect, before explaining at least one embodiment of the invention in detail, it is to be understood that the invention is not limited in its application to the details of construction and to the arrangements of the components set forth in the following description or illustrated in the drawings. The invention is capable of embodiments in addition to those described and of being practiced and carried out in various ways. Also, it is to be understood that the phraseology and terminology employed herein, as well as in the abstract, are for the purpose of description and should not be regarded as limiting.

As such, those skilled in the art will appreciate that the conception upon which this disclosure is based may readily be utilized as a basis for the designing of other structures, methods and systems for carrying out the several purposes of the present invention. It is important, therefore, that the claims be regarded as including such equivalent constructions insofar as they do not depart from the spirit and scope of the present invention.

### BRIEF DESCRIPTION OF THE DRAWINGS

FIG. 1 is a schematic diagram of an apparatus for forming a silicon ribbon according to an embodiment of the present invention.

FIG. 2 is a graph of a representative temperature profile of an Si ribbon within the thermal control zone of the apparatus illustrated in FIG. 1.

FIG. 3 is a flowchart illustrating the steps a method of forming the silicon ribbon illustrated in FIG. 1 according to an embodiment of the present invention.

### DETAILED DESCRIPTION

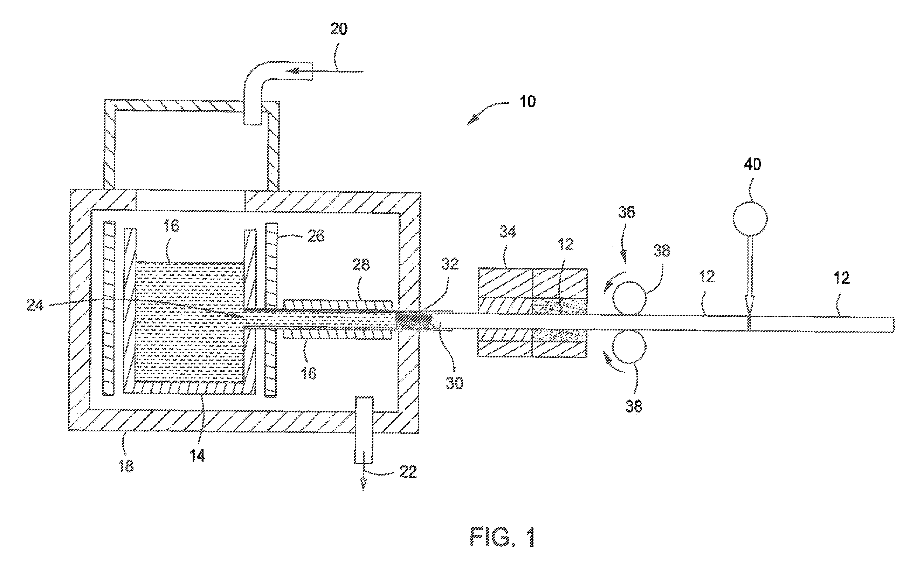

The invention will now be described with reference to the drawing figures, in which like reference numerals refer to like parts throughout. FIG. 1 is a schematic diagram of an apparatus 10 for forming a silicon ribbon 12 according to an embodiment of the present invention. As illustrated in FIG. 1, the apparatus 10 includes a crucible 14 (i.e., a vessel) configured to contain (i.e., hold) a silicon melt 16. The melt 16 illustrated in FIG. 1 is formed by melting polysilicon feedstock within the crucible 14. However, the melt 16 may also be formed by heating any other material(s) that will become apparent to one of skill in the art to use upon practicing one or more embodiments of the present invention.

According to certain embodiments of the present invention, the crucible 14 is a graphite-supported and substantially rectangular quartz vessel. However, materials other than quartz may also be used to form the crucible 14. Also, other crucible configurations/geometries are also within the scope of the present invention.

Although not illustrated in FIG. 1, according to certain embodiments of the present invention, one or more ceramic coatings (e.g., Si₃N₄, SiO₂) may be applied to portions of or to all surfaces of the crucible 14. Typically, these coatings are configured to reduce the dissolution of oxygen from the crucible 14 to the melt 16, and prevent or at least reduce adhesion of silicon melt to the crucible walls. Non-ceramic coatings and/or coatings serving other functions (e.g., increased surface hardness/scratch resistance) are also within the scope of the present invention.

As illustrated in FIG. 1, a crucible heating system 26 is positioned adjacent to the crucible 14. According to certain embodiments of the present invention, the crucible heating system 26 is configured to maintain the silicon melt 16 in a liquid state. In addition, the crucible heating system 26 may also be configured to melt a solid material (e.g., polycrystalline silicon in the above-discussed feedstock) that may get introduced into the crucible 14, thereby forming the silicon melt 16. In the embodiment of the present invention illustrated in FIG. 1, the crucible heating system 26 includes a pair of graphite resistance heaters that are attached to sidewalls of the chamber 18. However, other types of heating elements and/or alternate positioning thereof are also within the scope of the present invention. For example, a portion of the heating system 26 may be positioned below the crucible 14, or operated in a multi-zone heating configuration.

The crucible 14 and melt 16 illustrated in FIG. 1 are contained (i.e., enclosed) within an insulated chamber 18. The insulated chamber 18 may be made from any insulating material(s) capable of reducing or minimizing heat loss and of withstanding the high temperatures associated with silicon processing. At the top of the insulated chamber 18 illustrated in FIG. 1 is positioned a gas inlet 20 and at the bottom of the insulated chamber 18 is positioned a vacuum pump 22. However, no particular restrictions are placed upon the positioning either of the gas inlet 20 or of the vacuum pump 22. Also, multiple inlets/outlets are within the scope of the present invention, thus allowing for redundancies and/or for gas mixtures to be introduced into the insulated chamber 18.

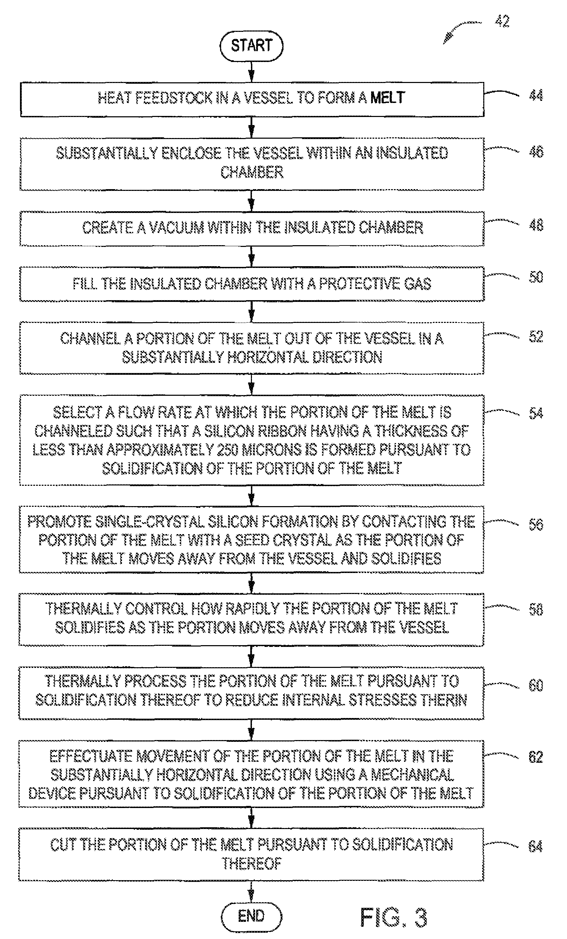

According to certain embodiments of the present invention, the vacuum pump 22 is configured to create a vacuum within the insulated chamber 18 and the gas inlet 20 is configured to introduce a protective gas or gas mixture (e.g., an inert gas) into the insulated chamber 18. As will be discussed in more detail below with reference to the flowchart illustrated in FIG. 3, using the gas inlet 20 and vacuum pump 22 illustrated in FIG. 1, an inert atmosphere may be introduced into the insulated chamber 18. As such, the quality of the silicon melt 16 may be maintained (i.e., the melt 16 may be protected from contamination, oxidation, etc.) by maintaining an appropriate pressure of inert gas (e.g., argon) within the insulated chamber 18. Also, the flow rate of the melt 16 out of the crucible 14 may be influenced by the pressure level of the gas. In other words, the gas pressure above the melt 16 may be increased or decreased to exert more or less pressure upon the top of the silicon melt 16.

As illustrated in FIG. 1, a channel 24 is positioned adjacent to the crucible 14. When in the open position illustrated in FIG. 1, the channel 24 allows for the silicon melt 16 to flow therethrough. Also illustrated in FIG. 1 is a channel heating system 28 that is positioned adjacent to the channel 24. According to certain embodiments of the present invention, at least a portion, and sometimes all, of both the channel 24 and channel heating system 28 are contained within the insulated chamber 18. Typically, the channel heating system 28 is configured to control the temperature of the silicon melt 16 flowing through the channel 24 as the melt 16 proceeds further from the crucible 14 and towards solidification.

Another component of the apparatus 10 illustrated in FIG. 1 is a holder 30 that is configured to support a silicon seed crystal 32. As the melt 16 begins to flow out of the crucible 14, the holder 30 initially positions the seed crystal 32 in contact with the melt 16 at a predetermined location on the outside of the crucible 14. At this location, the temperature of the melt 16 is such that the seed crystal 32 is capable of initiating the formation of the monocrystalline silicon ribbon 12 illustrated in FIG. 1.

In addition to supporting the seed crystal 32, the holder 30 is also configured to move the seed crystal 32 in a substantially horizontal direction away from the crucible 14 once the above-mentioned ribbon formation has been initiated. In other words, the holder 30 is configured to pull the seed crystal 32 and any solidified silicon adhered thereto through the channel 24 and away from the crucible 14 as illustrated in FIG. 1. In turn, this allows for more melt 16 to flow out of the crucible 14, to solidify and to form more ribbon 12,

In FIG. 1, a thermal control zone 34 is illustrated as being positioned adjacent to the channel 24 and external to the insulated chamber 18. According to certain embodiments of the present invention, the thermal control zone 34 is configured to thermally treat the silicon melt 16 pursuant to the solidification thereof (i.e., after the solid silicon ribbon 12 has formed). More specifically, the thermal control zone 34 is used to gradually lower the temperature of the silicon ribbon 12, thereby substantially eliminating or at least greatly reducing thermal stresses within the ribbon 12. If necessary, the thermal control zone 34 may also be configured to anneal the ribbon 12, thereby reducing internal mechanical stresses therein and further reducing the probability of the ribbon 12 cracking.

In order to ensure that silicon travels continuously through the apparatus 10 as the silicon transitions between being part of the silicon melt 16 and being part of the silicon ribbon 12, a pulling system 36 is also positioned adjacent to the channel 24. In FIG. 1, the pulling system 36 is illustrated as being positioned on the opposite side of the thermal control zone 34 as the channel 24. According to certain embodiments of the present invention, the speed of the pulling system 36 is carefully controlled to ensure a stable and uniform formation (i.e., growth) of the silicon ribbon 12. As will be discussed in more detail below, the exemplary pulling system 36 illustrated in FIG. 1 includes a pair of rollers 38 that are is frictional contact with a completely solidified portion of the silicon ribbon 12. However, other pulling system 36 configurations may also be used according to the present invention and the pulling system 36 may be moved to other positions relative to the other components of the apparatus 10 illustrated in FIG. 1.

In operation, as the rollers 38 rotate as illustrated in FIG. 1 (i.e., upper roller rotating counterclockwise and lower roller rotating clockwise), the silicon ribbon 12 between the rollers 38 is moved (i.e., is either pushed or pulled, depending on the frame of reference chosen) away from the insulated chamber 18. As such, the ribbon 12 draws the seed crystal 32 away from the crucible 14 and more of the silicon melt 16 is capable of flowing out of the crucible 14.

According to certain embodiments of the present invention, the pulling system 36 is configured to move a solidified portion the silicon melt 16 (i.e., a portion of the silicon ribbon 12) in a substantially horizontal direction using the rollers 38. However, other devices configured to promote movement of the silicon ribbon 12 away from the insulated chamber 18 are also within the scope of the present invention.

In addition to all of the other above-discussed components, FIG. 1 also illustrates that a cutting system 40 is positioned adjacent to the channel 24 and on the opposite side of the pulling system 36 from the thermal control zone 34. According to certain embodiments of the present invention, the cutting system 40 is configured to cut the silicon melt 16 pursuant to the solidification thereof (i.e., after the melt 16 has solidified into the silicon ribbon 12). In order to perform this function, the cutting system 40 may include one or more saws, one or more lasers and/or any other device(s)/component(s) capable of cutting the silicon ribbon 12 into two or more pieces.

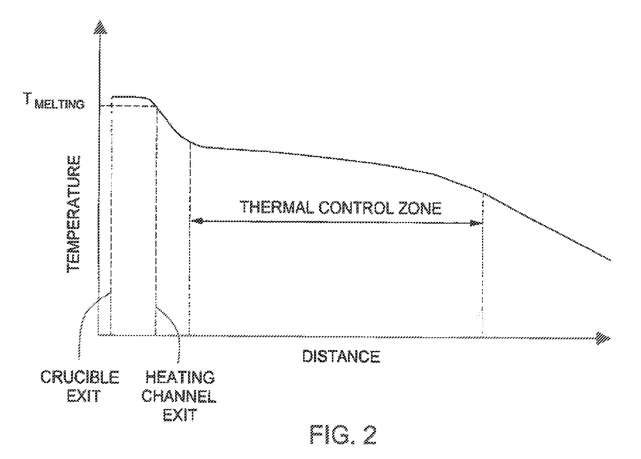

FIG. 2 is a graph of a representative temperature profile of a silicon ribbon through the apparatus 10 illustrated in FIG. 1. As illustrated in FIG. 2, the temperature remains relatively constant from the time that the silicon melt 16 exits the crucible 14 and enters the heating channel 28. The temperature drops relatively quickly from the time that the silicon melt 16 exits the heating channel 28, where the melt 16 typically begins to solidify into the ribbon 12 (i.e., the temperature drops below the melting temperature, T_{melting}). Subsequently, the silicon ribbon 12 enters the thermal control zone 34. Once in the zone 34, however, the rate of cooling slows in order to reduce/minimize any thermal shock in the ribbon 12

As mentioned above, according to certain embodiments of the present invention, the temperature is held relatively steady for a selected distance within the thermal control zone 34 so as to allow for internal stresses within the ribbon 12 to be annealed out. Next, as the silicon ribbon 12 nears the exit of the thermal control zone 34, the temperature again is allowed to drop relatively quickly. Finally, pursuant to exiting the thermal control zone 34, the silicon ribbon 12 is allowed to cool under ambient conditions until the ambient temperature is eventually reached.

FIG. 3 is a flowchart 42 illustrating the steps a method of forming the silicon ribbon 12 illustrated in FIG. 1 according to an embodiment of the present invention. It should be noted that, using devices/systems and/or methods according to the present invention, monocrystalline silicon ribbon may be formed that has long minority-carrier life, reduced impurities and/or reduced defect levels. In other words, by implementing certain embodiments of the present invention, silicon ribbon having a cell efficiency equivalent to monocrystalline silicon wafers may be obtained that otherwise would have to be formed by either the CZ or DSS method.

According to the representative method illustrated in FIG. 3, the first step (i.e., step 44) of the flowchart 42 specifies heating a batch of feedstock (e.g., solid polysilicon) in a vessel (e.g., the crucible 14 illustrated in FIG. 1) to form a melt (e.g,. the above-discussed silicon melt 16). Although no particular restrictions are made on the heating temperature, the composition (e.g., impurity content) of the feedstock being melted or on the geometry or composition of the vessel, parameters and compositions prevalent within the semiconductor industry are chosen according to certain embodiments of the present invention.

According to step 46, the vessel is at least substantially enclosed within an insulated chamber (e.g,. insulated chamber 18). Then, according to step 48, a vacuum is created within the insulated chamber. No particular restrictions are placed on the actual pressure attained with the insulated chamber. However, according to certain embodiments of the present invention, a nominal pressure of 5 torr is attained. Pursuant to step 48, as specified in step 50, the insulated chamber is filled with a protective (e.g., inert) gas. According to certain embodiments of the present invention, an argon environment is introduced into the insulated chamber during step 48. However, environments including other inert gases and/or other gases or mixtures that would prevent the silicon melt from undergoing chemical reactions may also be used.

As stated in step 52, a portion of the melt is then channeled out of the vessel in a substantially horizontal direction. According to certain embodiments of the present invention, step 52 is implemented according to the parameters set forth in step 54 which specifies that a flow rate be selected at which the portion of the melt is channeled such that a silicon ribbon having a thickness of less than approximately 250 microns is formed pursuant to solidification of the portion of the melt. As one of skill in the art will appreciate upon practicing one or more embodiments of the present invention, parameters such as, for example, the configuration/dimensions of the apparatus 10 illustrated in FIG. 1 and the processing temperatures (e.g., temperature of the silicon melt 16, temperatures within the thermal control zone 34, etc.) will affect which flow rate will be selected when implementing step 54. The desired dimensions of the silicon ribbon (e.g., thickness and width) will also affect which flow rate is selected.

The next step illustrated in FIG. 3 is step 56, which specifies promoting single-crystal silicon formation by contacting the portion of the melt with a seed crystal as the portion of the melt moves away from the vessel and solidifies. With reference to FIG. 1, during step 56, the seed crystal 32 makes initial contact with the silicon melt 16 as the melt 16 begins to flow out of the crucible 14, Then, as the seed crystal 32 is moved out of the insulated chamber 18 and toward the thermal control zone 34, the melt 16 is drawn along with the crystal 32, cooling and eventually solidifying.

Pursuant to step 56, step 58 specifies thermally controlling how rapidly the portion of the melt solidifies as the portion moves away from the vessel. According to certain embodiments of the present invention, the thermal control specified in step 56 results in at least a portion of the cooling profile illustrated in FIG. 2. However, other cooling profiles are also within the scope of the present invention, including those that do not rely on the presence of a thermal control zone 34.

According to step 60, pursuant to the solidification specified in step 58, the portion of the melt mentioned in step 58 is thermally processed to reduce internal stresses therein. In other words, after a portion of the silicon melt 16 has solidified into a portion of the silicon ribbon 12 illustrated in FIG. 1, that portion of the silicon ribbon 12 is effectively annealed.

The next step illustrated in FIG. 3 is step 62, which specifies effectuating movement of the portion of the melt in the substantially horizontal direction using a mechanical device pursuant to solidification of the portion of the melt. According to certain embodiments of the present invention, an apparatus similar or identical to the roller-based pulling system 36 illustrated in FIG. 1 is used. However, other devices that allow for and/or promote and/or effectuate movement (e.g., push or pull) of the silicon in a substantially horizontal direction as the silicon solidifies from a melt and into a ribbon are also within the scope of the present invention.

The final step in the flowchart 42 is step 64, which specifies cutting the portion of the melt pursuant to the solidification thereof. As discussed above in relation to the cutting system 40 illustrated in FIG. 1, step 64 may be implemented, for example, using a device or system that includes at least one of a saw or a laser. However, according to certain embodiments of the present invention, any other system/device capable of cutting a silicon ribbon into two or more pieces may also be used.

The many features and advantages of the invention are apparent from the detailed specification, and thus, it is intended by the appended claims to cover all such features and advantages of the invention which fall within the true spirit and scope of the invention. Further, since numerous modifications and variations will readily occur to those skilled in the art, it is not desired to limit the invention to the exact construction and operation illustrated and described, and accordingly, all suitable modifications and equivalents may be resorted to, falling within the scope of the invention.

## Claims

1. An apparatus for forming a silicon ribbon, the apparatus comprising:
a crucible configured to contain a silicon melt;
a channel positioned adjacent to the crucible and configured to allow the melt to flow therethrough;
a channel heating system positioned adjacent to the channel and configured to control temperature of the melt flowing through the channel; and
a holder configured to support a silicon seed crystal in contact with the melt and further configured to move the silicon seed crystal in a substantially horizontal direction.

2. The apparatus of claim 1, further comprising:
an insulated chamber within which the crucible is contained.

3. The apparatus of claim 2, further comprising:
a gas inlet configured to introduce a protective gas into the insulated chamber;
a vacuum pump configured to create a vacuum within the insulated chamber; and
wherein the channel and channel heating element are contained within the insulated chamber.

4. The apparatus of claim 1, further comprising:
a thermal control zone positioned adjacent to the channel and configured to thermally treat the melt pursuant to solidification thereof.

5. The apparatus of claim 1, further comprising:
a cutting system positioned adjacent to the channel and configured to cut the melt pursuant to solidification thereof.

6. The apparatus of claim 1, further comprising:
a pulling system positioned adjacent to the channel and configured to pull a solidified portion of the melt in a substantially horizontal direction.

7. The apparatus of claim 1, further comprising:
a crucible heating system positioned adjacent to the crucible and configured to maintain the silicon melt in a liquid state.

8. A method of forming a silicon ribbon, the method comprising:
heating silicon in a vessel to form a melt;
channeling a portion of the melt out of the vessel in a substantially horizontal direction; and
promoting single-crystal silicon formation by contacting the portion of the melt with a seed crystal as the portion of the melt moves away from the vessel and solidifies.

9. The method of claim 10, further comprising:
substantially enclosing the vessel within an insulated chamber;
creating a vacuum within the insulated chamber; and
substantially filling the insulated chamber with a protective gas.

10. The method of claim 10, further comprising:
thermally controlling how rapidly the portion of the melt solidifies as the portion moves away from the vessel[[;]].

11. The method of claim 14, wherein the thermally controlling step and solidification occurs within an insulated chamber that includes the vessel.

12. The method of claim 10, further comprising:
selecting a flow rate at which the portion of the melt is channeled such that a silicon ribbon having a thickness of less than approximately 250 microns is formed pursuant to solidification of the portion of the melt.

13. The method of claim 10, further comprising:
thermally processing the portion of the melt pursuant to solidification thereof to reduce internal stresses therein.

14. The method of claim 10, further comprising:
effectuating movement of the portion of the melt in the substantially horizontal direction using a mechanical device pursuant to solidification of the portion of the melt.

15. The method of claim 10, further comprising:
cutting the portion of the melt pursuant to solidification thereof.
